(19) **Europäisches Patentamt**

**European Patent Office**

**Office européen des brevets**

(11) **EP 0 563 719 B1**

(12) **EUROPÄISCHE PATENTSCHRIFT**

(45) Veröffentlichungstag und Bekanntmachung des Hinweises auf die Patenterteilung:
**20.12.2000 Patentblatt 2000/51**

(51) Int. Cl.$^7$: **H03K 7/00**, H03M 1/00, H03M 3/00

(21) Anmeldenummer: **93104616.3**

(22) Anmeldetag: **20.03.1993**

(54) **Verfahren zur digitalen Modulation**

Digital modulating method

Méthode de modulation numérique

(84) Benannte Vertragsstaaten:
**DE FR GB IT**

(30) Priorität: **02.04.1992 DE 4210966**

(43) Veröffentlichungstag der Anmeldung:
**06.10.1993 Patentblatt 1993/40**

(73) Patentinhaber:
**EADS Deutschland Gmbh**
**81663 München (DE)**

(72) Erfinder:
• **Fischer, Horst-Dieter**
**W-8025 Unterhaching (DE)**

• **Bittner, Helmut**
**W-8000 München 70 (DE)**

(56) Entgegenhaltungen:
**EP-A- 0 046 151**   **EP-A- 0 101 302**
**FR-A- 2 546 688**

• **JOURNAL OF GUIDANCE, CONTROL AND DYNAMICS, Bd.13, Nr.6, November 1990, WASHINGTON,DC,US Seiten 1014 - 1022 T. C. ANTHONY ET AL.: 'Pulse-Modulated Control Synthesis for a Flexible Spacecraft'**

**Beschreibung**

Die Erfindung betrifft ein digitales Modulationsverfahren gemäß dem Oberbegriff des Patentanspruchs 1.

In Regelungsverfahren bzw. -vorrichtungen zu verwendende Stellglieder, die aufgrund ihrer einfachen, billigen und zuverlässigen Bauweise oder zur Ausschaltung unerwünschter Leckverluste nur die Funktionszustände EIN/AUS aufweisen, wie etwa Strömungssteuerventile, Reaktionstriebwerke, Dosierungsmechanismen, Temperaturregelschalter, Dreipunktschaltglieder, Magnetspulen und dgl., müssen zur Erzeugung einer Ausgangsgröße, die im zeitlichen Mittel einem vorgegebenen, zeitlich veränderlichen Führungssignal folgen soll, mit Impulsen angesteuert werden, deren Pulsweite, Pulsfrequenz und/oder Impuls-Zeit-Fläche der Führungsgröße nach vorgegebenen Gesetzmäßigkeiten folgt und dieser insbesondere direkt proportional ist.

Zur Umwandlung eines derartigen Führungssignals in eine äquivalente Impulsfolge werden im allgemeinen Modulatoren verschiedener Varianten verwendet, etwa Pulsweitenmodulatoren, Pulsfrequenzmodulatoren, Pulsweiten-Pulsfrequenz-Modulatoren (PWPF) oder Pseudo-Rate-Modulatoren. Für technische Anwendungen in geschlossenen Regel kreisen ist dabei nicht nur die Form der Impulsfolge und ihre Proportionalität zu dem ihr entsprechenden Eingangssignal, sondern insbesondere auch deren Phasenlage bezüglich der zeitlichen Änderung des Führungssignals von ausschlaggebender Bedeutung, da Stabilität und dynamisches Verhalten eines Regelkreises und somit die Qualität eines Regelvorganges entscheidend davon abhängen. Da bekanntlich alle in der Praxis vorkommenden, zu regelnden physikalischen Systeme (Regelstrecken) Verzögerungscharakter haben, d.h. in der Frequenzgangdarstellung ihrer Ausgangs-Eingangs-Signalverhältnisse negative Phasendrehung aufweisen, sind bei stark verzögerungsbehafteten Regelstrecken und Einsatz der o.g. Art von Stellgliedern vor allem solche Modulationsverfahren zur Umsetzung ihrer Ansteuersignale vorteilhaft, die gleichzeitig eine positive Phasendrehung, d.h. Phasenvorhalt, der in ihrem Ausgangspulsmuster enthaltenen Grundschwingung gegenüber dem Eingangssignal erzeugen.

Solche günstigen Eigenschaften weisen insbesondere die o.g. Pseudo-Rate-Modulatoren auf, die ein Ausgangssignal erzeugen, das nicht nur der Amplituden-Zeit-Fläche des Eingangssignals, sondern auch dessen Änderungsgeschwindigkeit (Pseudo-Rate) proportional ist. Bei Verwendung anderer Modulatortypen müßten zur Erzeugung gleicher Stabilitätseigenschaften eines Regelkreises zusätzliche, Vorhalt erzeugende Reglernetzwerke eingesetzt werden, um den entsprechenden positiven Phasenwinkel zu gewinnen, was jedoch eine Verschlechterung der Signal-Rausch-Verhältnisse und zusätzlichen Realisierungsaufwand bedingen würde.

In letzter Zeit werden in zunehmendem Maße digitale Regler eingesetzt, so daß auch die Verwendung digitaler Modulatoren wünschenswert ist. Gerade hier wären die günstigen, Vorhalt erzeugenden Eigenschaften eines Pseudo-Rate-Modulators von besonderem Vorteil, da durch den unvermeidlichen Einsatz von Abtast-Halte-Gliedern, durch Totzeiten in den die Reglernetzwerke eventuell ersetzenden Digitalrechnern sowie durch Ein- und Ausgangsverzögerungen und dgl. zusätzliche Phasenverluste entstehen, die sich nachteilig auf Stabilität und Dynamik der Regelkreise auswirken.

Die Simulation der Funktionselemente eines analogen Pseudo-Rate-Modulators in einem digitalen Rechenwerk ist zwar prinzipiell möglich, erfordert aber extrem kurze Rechenzyklen, wenn ein einem analogen Modulator entsprechendes dynamisches Verhalten sichergestellt werden soll. Ein praktischer Vergleich der Funktionsmerkmale für typische Anwendungsfälle zeigt, daß Zyklusraten von 1 bis 2,5 kHz für die Abarbeitung der Modulatorroutinen notwendig wären, d.h. etwa 20- bis 50-fach höhere Abtastraten als für die Regelkreisalgorithmen erforderlich sind. Dies hätte eine entsprechend hohe Belastung der Prozeßrechner und unerwünschte Belegung der höchsten Prioritätsebenen für die Rechenabläufe zur Folge.

Ein Verfahren der eingangs genannten Art ist aus der US-A1 4 599 697 bzw. der EP-A-0 101 302 bekannt. Dort ist ein auf der Verwendung einer digitalen PWPF-Modulation beruhendes Lageregelungsverfahren für Satelliten beschrieben. Der Satellit stellt die Regelstrecke dar, die Regelgrößen sind Lagewinkel um die drei Satellitenachsen. Meßglieder in Form von Erd- und Sonnensensoren sowie Kreiseln messen die Istwerte der Lagewinkel und Winkelgeschwindigkeiten. Ein Regler bestimmt anhand dieser Werte Regelabweichungen von vorgebbaren Sollwerten und erzeugt Fehlersignale in Form digitaler Abtastwerte, die während der Dauer jedes einzelnen einer Reihe aufeinanderfolgender Zeitintervalle (Abtastperioden) jeweils konstant bleiben, insgesamt jedoch zeitlich veränderlich sind.

Mittels eines die Fehlersignale als Eingangssignal verwendenden, digitalen PWPF-Modulationsverfahrens werden Ausgangssignale erzeugt, welche eine Folge von positiven und/oder negativen Impulsen konstanter Amplitude sowie variabler Pulsweite und -frequenz repräsentieren. Es handelt sich dabei um ein Simulationsverfahren, bei dem jede Abtastperiode in ein festes Zeitraster eingeteilt und die Modulatorausgangszustände für sämtliche sich dadurch ergebenden, zwischen äquidistanten Zeitpunkten liegenden Subintervalle berechnet werden. Diese Berechnungen nehmen jeweils einen Teil der Abtastperiode in Anspruch, und die berechnete Impulsfolge wird im nächsten Abtastintervall abgerufen und zur Ansteuerung von diskrete Stellimpulse liefernden Stellgliedern, wie z.B. Lageregelungsdüsen, verwendet, um die Regelgrößen der Regelstrecke, nämlich die Lagewinkel, auf den gewünschten Werten zu halten.

Jedes Abtastintervall $T_1$ ist dabei gemäß einem vorgebbaren, dann aber festen Raster in beispielsweise vier

gleiche Teile $T_2$ unterteilt. Für jedes dieser Subintervalle wird die Modulatorausgangsgröße berechnet, und zwar unabhängig davon, ob eine Veränderung der Ausgangsgröße erfolgt oder nicht. Es werden also im allgemeinen viel mehr Rechenzyklen (PWPF-Schleifen) durchgeführt als Schaltpunkte auftreten. Geschaltet werden kann nur an den Grenzen der Subintervalle, d.h. die optimalen Schaltpunkte werden nicht oder nur selten getroffen. Die je 4 Rechenzyklen für alle drei Achsen werden gleich zu Beginn eines jeden Abtastintervalls durchgeführt. Dies dauert insgesamt 12 ms, d.h. knapp 1/5 der Dauer des Abtastintervalls ($T_1$ = 64 ms). Die Ergebnisse der Rechenzyklen werden jedoch erst im nächsten Abtastintervall gleich zu Beginn abgerufen und zur Düsenansteuerung verwendet.

Es wird also ein konstantes Raster potentieller Schaltpunkte vorgegeben, das dann mit berechneten Schaltzuständen aufgefüllt wird.

Dieses bekannte Simulationsverfahren hat demzufolge den Nachteil, daß wegen des fest vorgegebenen Zeitrasters für jede Abtastperiode die realen Schaltzeitpunkte eines analogen Modulators, dessen Verhalten digital nachgebildet werden soll, nicht genau getroffen werden, und daß außerdem ein hoher Rechenaufwand erforderlich ist, weil viele Rechenzyklen zwischen den Schaltpunkten zu absolvieren sind, deren Ergebnis lediglich ist, daß das simulierte Ausgangssignal seinen Zustand nicht ändert. Beide Nachteile beeinflussen sich gegenläufig, d.h. bei einer möglichen Erhöhung der Genauigkeit der Schaltzeitpunktermittlung mit Hilfe einer engeren Schachtelung des Zeitrasters und damit einer Erhöhung der Anzahl der Rechenzyklen für eine Abtastperiode steigt gleichzeitig der Rechenaufwand und umgekehrt.

Der Erfindung liegt daher die Aufgabe zugrunde, ein Verfahren der eingangs genannten Art so auszubilden, daß eine Verringerung des Rechenaufwandes bei gleichzeitiger Erhöhung der Genauigkeit der Schaltzeitpunktbestimmung resultiert.

Diese Aufgabe wird gemäß der Erfindung durch die im kennzeichnenden Teil des Patentanspruchs 1 genannten Merkmale gelöst. Vorteilhafte Ausgestaltungen des erfindungsgemäßen Verfahrens sind in den Unteransprüchen 2 bis 8 genant.

Gemäß der Erfindung sind also für jedes Zeitintervall (Abtastperiode) direkt die Ein- und Ausschaltzeitpunkte der Impulse sowie deren Vorzeichen zu berechnen. Das Prinzip der Simulation des Verhaltens eines analog ausgeführten Modulators wird damit verlassen. Die zu Beginn jedes neuen Zeitintervalls jeweils erneut vorzunehmende Berechnung (Operationszyklus) geschieht mit sehr hoher Geschwindigkeit innerhalb eines im Vergleich zur Dauer des Zeitintervalls sehr kurzen Zeitabschnitts, so daß gleich zu Anfang die gesamte für das laufende Zeitintervall geltende Impulsfolge zur Verfügung steht. Dabei wird kein unnötiger Rechenaufwand für die Berechnung von Zuständen zwischen den Schaltzeitpunkten betrieben, sondern vielmehr werden lediglich diejenigen Zeitpunkte bestimmt, zu denen Impulse ein- bzw. abzuschalten sind, sowie die für die einzuschaltenden Impulse jeweils erforderlichen Vorzeichen. Die entsprechenden Berechnungen werden in einer Rechenvorrichtung durchgeführt, welche Rechenwerke, Speicher und Komparatoren enthält. Neben den die digitalisierten Fehlersignale repräsentierenden Eingangssignalen werden der Rechenvorrichtung noch Modulatorparameter zugeführt, welche den nachzubildenden analogen Modulatortyp kennzeichnen.

Selbstverständlich sind die Vorschriften, nach denen in der Rechenvorrichtung gearbeitet wird, je nach dem nachzubildenden Modulatortyp verschieden.

Der Vorteil des erfindungsgemäßen Verfahrens liegt also vor allem darin, daß eine sehr genaue Berechnung der Schaltzeitpunkte möglich ist, wobei im Vergleich zu dem bekannten Simulationsverfahren der insgesamt erforderliche Rechenaufwand deutlich verringert ist. Die Ausgangssignale der Rechenvorrichtung können solange gespeichert werden, bis die gesamte einem Zeitintervall zuzuordnende Impulsfolge vorliegt. Das Auslesen dieses Speichers kann dann hinsichtlich der anzuwendenden Taktfrequenz mit beliebiger Genauigkeit erfolgen.

Die in den Unteransprüchen angegebenen Details beziehen sich auf den Fall, daß mit dem erfindungsgemäßen Verfahren ein Pseudo-Rate-Modulator in seiner Funktion nachgebildet werden soll. Wie bereits erwähnt, besitzt ein derartiger Modulator ebenso wie die diesbezügliche Variante des erfindungsgemäßen Verfahrens einen Phasenvorhalt erzeugende Eigenschaften. Auch bei dieser Variante ergibt sich selbstverständlich der Vorteil, daß innerhalb eines Operationszyklus nur so viele Rechenzyklen erforderlich sind, wie das entsprechende Abtastintervall bei einer analogen Realisierung des Modulators Ein- und Ausschaltzeitpunkte aufweisen würde. Bei einer digitalen Nachbildung eines Modulators des PWPF- oder eines anderen Typs wären die Ein- und Ausschaltzeitpunkte sowie deren Vorzeichen auf entsprechende Weise zu berechnen, nämlich unter Zugrundelegung des den jeweiligen Modulatortyp kennzeichnenden mathematischen Formalismus. Allerdings ist mit vom Pseudo-Rate-Typ abweichenden Modulatorversionen der gewünschte Phasenvorhalt nicht in gleicher Weise zu erzielen.

Im folgenden werden Ausführungsbeispiele der Erfindung anhand der Abbildungen näher beschrieben. Es zeigen in schematischer Weise:

Fig. 1    das Blockschaltbild einer Regelungsvorrichtung mit einem digitalen Modulator,
Fig. 2    das Blockschaltbild eines analogen Pseudo-Rate-Modulators,
Fig. 3    das Funktions- bzw. das Signalflußdiagramm einer Version des erfindungsgemäßen Modulationsverfahrens.

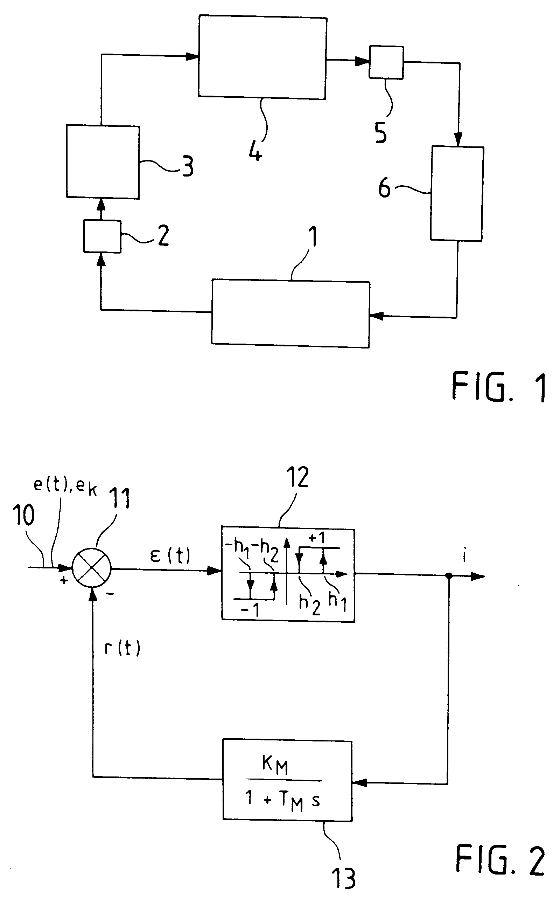

Fig. 1 zeigt eine Regelungsvorrichtung, die bei der Lageregelung von Satelliten zur Anwendung kommt. Der Satellit selbst ist als Regelstrecke 1 dargestellt. Er soll hinsichtlich seiner Orientierung im Raum stabilisiert werden, wozu die Winkellagen bezüglich Drehungen um seine satellitenfesten Koordinatenachsen auf vorgebbaren Sollwerten zu halten sind. Dazu sind zunächst Meßglieder 2 vorhanden, welche die Lagewinkel sowie ggf. auch die Winkelgeschwindigkeiten um die genannten Achsen messen. Diese Meßgrößen werden in einem Regler 3 verwertet, wo die Regelabweichungen von den Sollwerten bestimmt und nach dem Einzelfall angepaßten Regelgesetzen Fehlersignale erzeugt werden. Diese können kontinuierlich veränderlich sein, werden aber im Falle einer digitalen Regelung als diskrete Abtastwerte ausgegeben, die während der Dauer jedes einzelnen einer Reihe aufeinanderfolgender Zeitintervalle (Abtastperioden) jeweils konstant sind, über einen längeren Zeitraum jedoch zeitlichen Veränderungen unterliegen können.

Die Fehlersignale werden als Eingangssignale einem Modulator 4 zugeführt, welcher die Aufgabe hat, Ausgangssignale bereitzustellen, die eine Folge von diskreten, positiven und/oder negativen Impulsen konstanter Amplitude sowie variabler Pulsweite und -frequenz repräsentieren. Diese Ausgangssignale werden ggf. nach Zwischenspeicherung in einem nachgeschalteten Speicher 5 zur Ansteuerung einer Stellvorrichtung 6 verwendet, die diskrete Stellimpulse an die Regelstrecke 1 abgeben, konkret beispielsweise an Lageregelungsdüsen oder Reaktionsräder, die vom Satelliten mitgeführt werden. Dadurch sollen die Regelgrößen, also die o.g. Lagewinkel, auf den gewünschten Sollwerten gehalten werden.

Fig. 2 zeigt das Funktionsschaltbild eines Pseudo-Rate-Modulators, welcher im wesentlichen aus einem Dreipunkt-Hystereseglied 12 im Vorwärtszweig und einem linearen Verzögerungsglied erster Ordnung 13 im Rückführzweig sowie einem Summationsglied 11 besteht, in welchem ein Rückführsignal $r(t)$ von einem Eingangssignal $e(t)$ subtrahiert wird. Das dabei entstehende Differenzsignal $\varepsilon(t)$ gelangt an den Eingang des Hysteresegliedes 12, welches die Einschaltschwellen $\pm h_1$ und die Abschaltschwellen $\pm h_2$ aufweist und in bekannter Weise das Ausgangssignal $i = 0$ oder $i = \pm 1$ abgibt, je nach dem momentanen Wert von $\varepsilon(t)$ sowie dessen "Vorgeschichte". Das Ausgangssignal $i$ wird über das einen Verstärkungsfaktor $K_M$ und eine Zeitkonstante $T_M$ aufweisende Verzögerungsglied 13 zurückgeführt und gelangt als Rückführsignal $r(t)$ zum Summationsglied 11. Im Falle eines digitalen Modulators steht am Eingang ein während jeder Abtastperiode $\Delta t_k$ konstantes Eingangssignal $e_k$ an.

Der in Fig. 2 dargestellte Modulator ist vom Pseudo-Rate-Typ, da sich das Verzögerungsglied 13 im Rückführzweig befindet. Wie erwähnt erzeugt ein solcher Pseudo-Rate-Modulator (in einem von den Parametern $K_M$ und $T_M$ abhängigen Frequenzbereich) einen Phasenvorhalt gegenüber dem Eingangssignal, ein Effekt, der im vorliegenden Falle gerade besonders erwünscht ist.

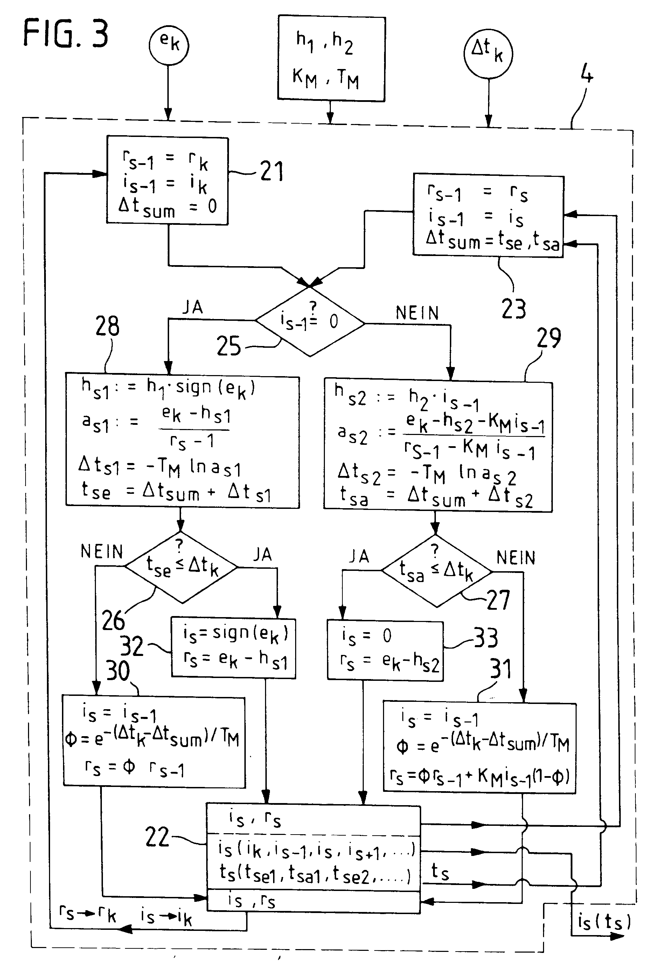

Die Fig. 3 zeigt ein Funktionsschaltbild eines erfindungsgemäßen Modulationsverfahrens, durch das ein Pseudo-Rate-Modulator digital nachgebildet wird. In dem speziellen hardwaremäßigen Ausführungsbeispiel sind zur Durchführung des Verfahrens Datenspeicher 21 bis 23, Komparatoren 25 bis 27 und Rechenwerke 28 bis 33 vorgesehen, welche die wesentlichen Elemente einer Rechenvorrichtung (Modulator 4) bilden. Zusätzliche, zur Ausführung digitaler Abläufe erforderliche Bauelemente, wie Taktgeber, Rechenregister und Speicherelemente in den Rechenwerken, sind nicht eigens dargestellt.

Zu Beginn eines jeden Zeitintervalls $\Delta t_k$ (Abtastperiode) liegt am Eingang des Modulators 4 das während der Dauer dieses Zeitintervalls konstante Eingangssignal $e_k$ an (k sei die laufende Nummer des k-ten Zeitintervalls). Dies löst einen Operationszyklus aus, der wiederum aus einer Reihe von Rechenzyklen besteht, deren jeder der Bestimmung eines Schaltzeitpunktes innerhalb der im Zeitintervall $\Delta t_k$ erforderlichen Folge von Ein- und Ausschaltzeitpunkten $t_{se}$ bzw. $t_{sa}$ dient. Es werden nur so viele Rechenzyklen durchgeführt, wie Ein- und Ausschaltzeitpunkte bei einem analogen Modulator mit denselben Parametern ($\pm h_1$, $\pm h_2$, $K_M$, $T_M$) und bei Anlegen desselben Eingangssignales $e_k$ anfallen würden. Im allgemeinen wird ein zusätzlicher Rechenzyklus nötig sein, mit dem festgestellt wird, daß der zuletzt berechnete Schaltzeitpunkt bereits in das nächste Zeitintervall $\Delta t_{k+1}$ fallen würde und somit nicht mehr zur laufenden Folge gehört..

Im einzelnen laufen folgende Verfahrensschritte ab:

Zu Beginn des Zeitintervalls $\Delta t_k$ liegen in einem ersten Datenspeicher 21 als Anfangswerte oder als Endzustände aus dem vorhergehenden Operationszyklus $\Delta t_{k-1}$ folgende Größen vor:

$r_{s-1} = r_k$       das Rückführsignal des Modulators,

$i_{s-1} = i_k$       das gerade vorliegende Ausgangssignal des Modulators entsprechend dem Schaltzustand AUS ($i = 0$) oder EIN ($i = \pm 1$), und

$\Delta t_{sum} = 0$       eine die Summe über alle vorliegenden Ein- und Ausschaltzeiträume $\Delta t_s$ eines laufenden Operationszyklus darstellende Hilfsgröße (mit ihrem Anfangswert 0).

In einem ersten Komparator 25 wird festgestellt, ob gilt: $i_{s-1} = 0$ oder $i_{s-1} \neq 0$, d.h. $i_{s-1} = \pm 1$. Im ersteren Falle wird in einem ersten Rechenwerk 28 der erste Einschaltzeitpunkt $t_{se}$ berechnet, bezogen auf den Beginn des Zeitintervalls $\Delta t_k$. Dies geschieht nach den folgenden Vorschriften:

$$h_{s1} := h_1 \, \text{sign}(e_k) \tag{1}$$

$$a_{s1} := \frac{e_k - h_{s1}}{r_{s-1}}$$

$$\Delta t_{s1} = - T_M \ln a_{s1}$$

$$t_{se} = \Delta t_{sum} + \Delta t_{s1}$$

wobei $h_{s1}$ und $a_{s1}$ Hilfsgrößen, $\Delta t_{s1}$ den Zeitraum bis zum Einschaltzeitpunkt $t_{se}$, $h_1$ und $T_M$ bereits erwähnte Modulatorparameter und ln den natürlichen Logarithmus bedeuten.

In einem nachfolgenden, zweiten Komparator 26 wird nun festgestellt, ob der Einschaltzeitpunkt $t_{se}$ noch innerhalb des laufenden Zeitintervalls $\Delta t_k$ liegt. Ist dies der Fall (JA), so werden die Werte für das Ausgangssignal $i_s$ sowie das Rückführsignal $r_s$ des Modulators zum Einschaltzeitpunkt $t_{se}$ in einem dritten Rechenwerk 32 berechnet gemäß der Vorschrift:

$$i_s = \text{sign}(e_k) \tag{2}$$

$$r_s = e_k - h_{s1}$$

Die sich als Endgrößen eines ersten Rechenzyklus innerhalb des laufenden Operationszyklus ergebenden Werte für $t_{se}$, $i_s$ und $r_s$ werden in einem zweiten Datenspeicher 22 abgelegt.

Damit ist der erste Einschaltzeitpunkt $t_{se}$ einschließlich des dazugehörigen Vorzeichens [sign($e_k$)!] bestimmt, und es muß nun errechnet werden, wann der entsprechende Impuls wieder abzuschalten ist. Dies geschieht folgendermaßen:

Die Zustandsgrößen $i_s$ und $r_s$ werden in einen Zwischenspeicher 23 übernommen, der für den nachfolgenden Rechenzyklus als Anfangswertspeicher dient. Für die in diesem Rechenzyklus zu verwendenden Größen $r_{s-1}$, $h_{s-1}$ und $\Delta t_{sum}$ werden im Zwischenspeicher 23 die genannten Werte $i_s$ und $r_s$ aufgenommen:

$$r_{s-1} = r_s \tag{3}$$

$$i_{s-1} = i_s$$

$$\Delta t_{sum} = t_{se}, \, t_{sa}$$

Zu Beginn des neuen Rechenzyklus wird in dem ersten Komparator 25 festgestellt, ob das Ausgangssignal $i_{s-1}$ des Modulators einem ein- oder ausgeschalteten Zustand ($i_{s-1} = \pm 1 \neq 0$ oder $i_{s-1} = 0$) entspricht. Da zuletzt ein Einschaltzeitpunkt berechnet wurde, gilt nun $i_{s-1} \neq 0$, so daß die NEIN-Entscheidung im Komparator 25 jetzt zur Berechnung des nächsten Ausschaltzeitpunktes $t_{sa}$ in einem zweiten Rechenwerk 29 führt, und zwar nach den Vorschriften:

$$h_{s2} := h_2 i_{s-1} \tag{4}$$

$$a_{s2} := \frac{e_k - h_{s2} - K_M i_{s-1}}{r_{s-1} - K_M i_{s-1}}$$

$$\Delta t_{s2} = - T_M \ln a_{s2}$$

$$t_{sa} = \Delta t_{sum} + \Delta t_{s2}$$

mit den Hilfsgrößen $h_{s2}$ und $a_{s2}$ sowie den oben bereits erläuterten Modulatorparametern $h_2$, $K_M$ und $T_M$, der Dauer des Einschaltzeitraumes $\Delta t_{s2}$ und der bisher auf den Wert $\Delta t_{sum} = t_{se}$ angestiegenen Summe über sämtliche Ein- und Ausschaltzeiträume innerhalb des laufenden Operationszyklus.

In einem dritten Komparator 27 wird nun wiederum festgestellt, ob der so berechnete Ausschaltzeitpunkt $t_{sa}$ noch innerhalb des laufenden Zeitintervalls $\Delta t_k$ liegt. Ist dies der Fall (JA), so werden in einem vierten Rechenwerk 33

die zum Ausschaltzeitpunkt $t_{sa}$ geltenden Ausgangs- und Rückführsignale $i_s$ bzw. $r_s$ des Modulators berechnet gemäß der Vorschrift:

$$i_s = 0 \qquad (5)$$

$$r_s = e_k - h_{s2}$$

Diese Größen und der Wert für den Ausschaltzeitpunkt $t_{sa}$ werden anschließend in den zweiten Datenspeicher 22 übernommen und die beiden Zustandsgrößen $i_s$ und $r_s$ wiederum dem Zwischenspeicher 23 zugeführt, so daß nunmehr der dritte Rechenzyklus zur Bestimmung des nächsten Einschaltzeitpunktes beginnen kann, und zwar nach einer JA-Entscheidung ($i_{s-1} = i_s = 0$) im ersten Komparator 25.

Die folgenden, im Falle weiterer JA-Entscheidungen in den zweiten und dritten Komparatoren 26 und 27 für das laufende Zeitintervall $\Delta t_k$ sich ergebenden Ein- und Ausschaltzeitpunkte werden analog zu der oben geschilderten Weise berechnet. Dabei wird der Wert für $\Delta t_{sum}$ nach jedem weiteren Rechenzyklus jeweils um $\Delta t_{s1}$ bzw. $\Delta t_{s2}$ aufgestockt. Im zweiten Datenspeicher 22 liegt somit schließlich eine Folge von Schaltzeitpunkten vor, die mit einem zusätzlichen laufenden Index folgendermaßen angegeben werden kann: $t_{se1}, t_{sa1}, t_{se2}, t_{sa2}, t_{se3}, t_{sa3}$ usw.

Irgendwann innerhalb des laufenden Operationszyklus tritt der Fall ein, daß der gerade berechnete Schaltzeitpunkt $t_{se}$ bzw. $t_{sa}$ nicht mehr innerhalb des geltenden Zeitintervalls $\Delta t_k$ liegen würde, verursacht durch das ständige Ansteigen von $\Delta t_{sum}$. Dann wird in einem der beiden Komparatoren 26 oder 27 eine NEIN-Entscheidung getroffen. In fünften und sechsten Rechenwerken 30, 31 sind nun noch die für das Ende des laufenden Zeitintervalls $\Delta t_k$ geltenden Zustandsgrößen $i_s$ und $r_s$ zu berechnen, und zwar unter Verwendung einer Transitionsfunktion $\Phi$ nach der Vorschrift

$$i_s = i_{s-1} - (\Delta t_k - \Delta t_{sum})/T_M \qquad (6)$$

$$\Phi = e$$

$$r_s = \Phi r_{s-1}$$

für den einen möglichen Fall, daß der zuletzt berechnete, nicht mehr ins Zeitintervall $\Delta t_k$ fallende Schaltzeitpunkt ein Einschaltzeitpunkt $t_{se}$ war ($t_{se} > \Delta t_k$), sowie gemäß der Vorschrift

$$i_s = i_{s-1} - (\Delta t_k - \Delta t_{sum})/T_M \qquad (7)$$

$$\Phi = e$$

$$r_s = \Phi r_{s-1} + K_M i_{s-1}(1 - \Phi)$$

für den anderen möglichen Fall, daß dieser zuletzt berechnete Zeitpunkt ein Ausschaltzeitpunkt $t_{sa}$ war ($t_{sa} > \Delta t_k$). Im laufenden Zeitintervall $\Delta t_k$ wird der zum zuvor berechneten Schaltzeitpunkt eingeleitete Schaltzustand beibehalten.

Die für das Ende des laufenden Operationszyklus und somit auch für das Ende des Zeitintervalls $\Delta t_k$ geltenden Zustandsgrößen $i_s$ und $r_s$ gemäß (6) oder (7) werden dann in den zweiten Datenspeicher 22 eingelesen und zu Beginn des folgenden Zeitintervalls $\Delta t_{k+1}$ als neue Anfangswerte an die Stelle der Größen $i_k$ und $r_k$ im ersten Datenspeicher 21 gesetzt.

Für die in den einzelnen Rechenzyklen zu berechnenden Aus- und Einschaltzeiträume $\Delta t_{s1}$ und $\Delta t_{s2}$ sowie die schließlich zu bestimmenden Transitionsfunktionen $\Phi$ können auch folgende Näherungsformeln verwendet werden:

$$\Delta t_{s1} = T_M \left(\frac{1}{a_{s1}} - 1\right) \qquad (8)$$

$$\Delta t_{s2} = T_M \left(\frac{1}{a_{s2}} - 1\right)$$

$$\Phi = \frac{T_M}{T_M + \Delta t_k - \Delta t_{sum}}$$

Bei Verwendung dieser Näherungen verringert sich der Rechenaufwand erheblich, insbesondere kann im Falle der Transitionsfunktion Φ die Berechnung einer transzendenten Exponentialfunktion auf einfache Grundoperationen zurückgeführt werden.

Am Ende des im Vergleich zur Dauer des zugehörigen realen Zeitintervalls $\Delta t_k$ sehr schnell absolvierten Operationszyklus enthält der zweite Datenspeicher 22 als Endspeicher 5 (Fig. 1) den genannten, für dieses Zeitintervall geltenden Modulationsverlauf in Form einer Folge von Ein- und Ausschaltzeitpunkten sowie dazugehörigen Vorzeichen der Impulse. Diese Informationen werden dann zu den jeweiligen Schaltzeitpunkten als positive oder negative Impulse konstanter Amplitude ($i = \pm 1$) sowie variabler Pulsweite und -frequenz repräsentierende Ausgangssignale ausgegeben.

Zur Realisierung des erfindungsgemäßen digitalen Modulationsverfahrens bieten sich neben klassischen Digitalbausteinen wie Flip-Flops, UND-Gatter, ODER-Gatter, Speicherregistern, Zählern und dergleichen auch hochintegrierte digitale Techniken an. Insbesondere läß sich ein digitaler Modulator als sogenannter ASIC, d.h. Anwendungs-Spezifischer Integrierter Schaltkreis (englisch: Circuit) aufbauen. Es kann auch zweckmäßig sein, die den einzelnen Rechenwerken zugeordneten Funktionen bzw. Algorithmen in geeigneten Gruppen zusammenzufassen und aus gemeinsamen Datenspeichern mit Anfangswerten und/oder zwischengespeicherten Zustandsgrößen zu versorgen. Eine konsequente Weiterführung führt schließlich zur Realisierung der das erfindungsgemäße Modulationsverfahren kennzeichnenden Gesetzmäßigkeiten, Algorithmen, Speicher- und Entscheidungsfunktionen in einem einzigen Rechenwerk oder als Programmroutine in einem zentralen digitalen Prozeßrechner.

Gemäß einem weiteren Merkmal der vorliegenden Erfindung soll bei der Realisierung insbesondere darauf geachtet werden, daß die systembedingten Modulatorparameter wie Ansprech- und Abschaltschwellen ($h_1$, $h_2$), Modulatorverstärkung ($K_M$) und Verzögerungszeitkonstanten ($T_M$) in Abhängigkeit von externen Signalen oder internen Betriebszuständen eines übergeordneten Regelkreises anpaßbar sind. Dies kann z.B. dadurch geschehen, daß die besagten Parameter beim Einschalten der digitalen Modulationseinrichtung bzw. beim Aufruf eines dieser äquivalenten Unterprogramms aus einem Festwertspeicher (ROM) in einen Schreib- und Lesespeicher (RAM) übernommen werden, dem über externe Datenverbindungen in adaptiver Weise neue Werte zugeführt werden können, welche die alten ersetzen. Damit wird sichergestellt, daß zum Einschaltzeitpunkt auch bei Fehlen einer externen Dateneingabe in jedem Fall brauchbare Parameterwerte verfügbar sind, die zwar nicht optimales Verhalten des zugehörigen, übergeordneten Regelkreises oder Prozesses gewährleisten, aber doch wenigstens eine einwandfreie Funktion sicherstellen.

Durch diese Anpassungsmöglichkeit läßt sich entweder bei Inbetriebnahme eines einen digitalen Modulator gemäß der Erfindung beinhaltenden Systems oder bei sich ändernden Betriebsbedingungen und Abweichungen der Systemparameter von ihren Nominalwerten immer wieder der optimale Betriebszustand einstellen. So sind beispielsweise Wirkungsgrad und Lebensdauer von Reaktionsdüsen von der Größe der Minimalimpulsdauer abhängig, die ihrerseits durch die o.g. Modulatorparameter ($h_1$, $h_2$, $K_M$, $T_M$) variierbar ist. In entsprechender Weise läßt sich auch der mehrfach erwähnte Vorhalteffekt über diese Parameter beeinflussen.

Schließlich soll nun noch angegeben werden, wieviele Rechenzyklen zur Bestimmung aller Ein- und Ausschaltzeitpunkte maximal notwendig sind, um die Schaltzustände über die gesamte Dauer eines vorgegebenen Zeit- oder Abtastintervalls $\Delta t_k$ festzulegen. Dies ist deswegen von Bedeutung, weil mit dem Auslesevorgang der errechneten Impulsfolge erst dann begonnen werden kann, wenn deren Ermittlung vollständig abgeschlossen ist und die Ablaufsteuerung digitaler Vorgänge in festen Zeitrahmen erfolgt. Unter Verwendung der bereits eingeführten Bezeichnungen wird die kürzeste Impulsfolgeperiode eines Pseudo-Rate-Modulators durch die Beziehung bestimmt:

$$T_{min} = 4T_M (h_1 - h_2)/K_M \qquad (9)$$

Die Zahl der Schaltzustände in einem vorgegebenen Zeitintervall $\Delta t_k$ wird also die nächstgelegene Integerzahl unterhalb des Wertes $2t_A/T_{min}$ nicht überschreiten.

Der so bestimmbaren Anzahl der Rechenzyklen zur Bestimmung der Schaltzustände ist dann noch der Rechenschritt zur Transition der internen Modulatorzustandsgrößen zum Ende des Abtastintervalls hinzuzufügen.

**Patentansprüche**

1. Digitales Modulationsverfahren zur Umformung eines während der Dauer jedes einzelnen einer Reihe aufeinanderfolgender Zeitintervalle jeweils konstanten Eingangssignals in Ausgangssignale, die eine Folge von positiven und/oder negativen Impulsen konstanter Amplitude sowie variabler Pulsweite und -frequenz repräsentieren, wobei das Eingangssignal und Modulatorparameter einer Rechenvorrichtung zugeführt werden, dadurch gekennzeichnet, daß mittels der Rechenvorrichtung zu Beginn eines jeden Zeitintervalls $\Delta t_k$ lediglich die Ein- und Ausschaltzeitpunkte $t_{se}$, $t_{sa}$ der Impulse sowie deren Vorzeichen für das jeweils laufende Zeitintervall $\Delta t_k$ direkt berechnet und als Ausgangssignale bereitgehalten werden.

2. Verfahren nach Anspruch 1, **dadurch gekennzeichnet,** daß zur Nachbildung eines Pseudo-Rate-Modulators die Einschaltzeitpunkte $t_{se}$ innerhalb des jeweiligen Zeitintervalls $\Delta t_k$ nach folgender Vorschrift berechnet werden:

$$t_{se} = \Delta t_{sum} - T_M \ln \frac{e_k - h_1 \text{sign}(e_k)}{r_{s-1}}$$

wobei $e_k$ das Eingangssignal während des k-ten Zeitintervalls, $h_1$ der Betrag der Einschaltschwelle der Hysterese des Modulators, $T_M$ die Zeitkonstante im Rückführzweig des Modulators, $r_{s-1}$ das interne Rückführsignal des Modulators zum jeweils vorhergehenden Ausschaltzeitpunkt $t_{sa}$ und $\Delta t_{sum}$ die Summe der für das laufende Zeitintervall $\Delta t_k$ zuvor berechneten, jeweils zwischen Ein- und Ausschaltzeitpunkten bzw. umgekehrt liegenden Ein- und Ausschaltintervalle bedeuten.

3. Verfahren nach Anspruch 1 oder 2, **dadurch gekennzeichnet,** daß zur Nachbildung eines Pseudo-Rate-Modulators die Ausschaltzeitpunkte $t_{sa}$ innerhalb des jeweiligen Zeitintervalls $\Delta t_k$ nach folgender Vorschrift berechnet werden:

$$t_{sa} = \Delta t_{sum} - T_M \ln \frac{e_k - (h_2 + K_M)i_{s-1}}{r_{s-1} - K_M i_{s-1}}$$

wobei $h_2$ den Betrag der Ausschaltschwelle der Hysterese des Modulators und $i_{s-1}$ den vorhergehenden Schaltzustand bedeuten.

4. Verfahren nach Anspruch 1, **dadurch gekennzeichnet,** daß zur Nachbildung eines Pseudo-Rate-Modulators die Einschaltzeitpunkte $t_{se}$ innerhalb des jeweiligen Zeitintervalls $\Delta t_k$ nach folgender Vorschrift berechnet werden:

$$t_{se} = \Delta t_{sum} - T_M \left( \frac{r_{s-1}}{e_k - h_1 \text{sign}(e_k)} - 1 \right)$$

5. Verfahren nach Anspruch 1 oder 4, **dadurch gekennzeichnet,** daß zur Nachbildung eines Pseudo-Rate-Modulators die Ausschaltzeitpunkte $t_{sa}$ innerhalb des jeweiligen Zeitintervalls $\Delta t_k$ nach folgender Vorschrift berechnet werden:

$$t_{sa} = \Delta t_{sum} + T_M \left( \frac{r_{s-1} - K_M i_{s-1}}{e_k - (h_2 + K_M)i_{s-1}} - 1 \right)$$

6. Verfahren nach einem der vorhergehenden Ansprüche, **dadurch gekennzeichnet,** daß die Berechnung der Folge von Ein- und Ausschaltzeitpunkten $t_{se}$ bzw. $t_{sa}$ für jedes einzelne Zeitintervall $\Delta t_k$ dann abgebrochen wird, wenn die Summe $\Delta t_{sum}$ aller bis dahin innerhalb des Zeitintervalls $\Delta t_k$ aufgelaufenden, zwischen Ein- und Ausschaltzeitpunkten und umgekehrt liegenden Ein- und Ausschaltintervalle $\Delta t_{se}$ bzw. $\Delta t_{sa}$ die Länge des Zeitintervalls übersteigt.

7. Verfahren nach Anspruch 6, dadurch gekennzeichnet, daß ein dem Endzeitpunkt eines im ausgeschalteten Zustand ($i_s = 0$) endenden Zeitintervalls $\Delta t_k$ zuzuordnendes Rückführsignal $r_s$ nach einer der folgenden Vorschriften berechnet wird:

$$r_s = r_{s-1} \exp\left( -\frac{\Delta_k - \Delta t_{sum}}{T_M} \right)$$

oder

$$r_s = \frac{r_{s-1} T_M}{T_M + \Delta t_k - \Delta t_{sum}}$$

8. Verfahren nach Anspruch 6, **dadurch gekennzeichnet,** daß ein dem Endzeitpunkt eines im eingeschalteten Zustand ($i_s = \pm 1$) endenden Zeitintervalls $\Delta t_k$ zuzuordnendes Rückführsignal $r_s$ nach einer der folgenden Vorschriften berechnet wird:

$$r_s = (r_{s-1} - K_M i_{s-1})\exp(- \frac{\Delta t_k - \Delta t_{sum}}{T_M}) + K_M i_{s-1}$$

oder

$$r_s = \frac{T_M(r_{s-1} - K_M i_{s-1})}{T_M + \Delta t_k - \Delta t_{sum}} + K_M i_{s-1}$$

**Claims**

1. Digital modulation method for converting an input signal, which is constant for the duration of each individual time interval of a series of successive intervals, into output signals which represent a sequence of positive and/or negative pulses of constant amplitude and variable pulse width and frequency, the input signal and modulator parameters being conveyed to a computing device, characterised in that by means of the computing device at the beginning of each time interval $\Delta t_k$ only the switch-on and switch-off moments $t_{se}$, $t_{sa}$ of the pulses and their signs for the respectively current time interval $\Delta t_k$ are calculated directly and kept in store as output signals.

2. Method according to claim 1, characterised in that in order to simulate a pseudo rate modulator the switch-on moments $t_{se}$ within the respective time interval $\Delta t_k$ are calculated in accordance with the following formula:

$$t_{se} = \Delta t_{sum} - T_M \ln \frac{e_k - h_1 \text{sign}(e_k)}{r_{s-1}}$$

wherein $e_k$ is the input signal during the k-th time interval, $h_1$ is the value of the switch-on threshold of the hysteresis of the modulator, $T_M$ is the time constant in the return branch of the modulator, $r_{s-1}$ is the internal return signal of the modulator for the respectively preceding switch-off moment $t_{sa}$, and $\Delta t_{sum}$ is the sum of the switch-on and switch-off intervals previously calculated for the current time interval $\Delta t_k$, between the switch-on and switch-off moments and vice versa respectively.

3. Method according to claim 1 or 2, characterised in that to simulate a pseudo rate modulator the switch-off moments $t_{sa}$ within the respective time interval $\Delta t_k$ are calculated in accordance with the following formula:

$$t_{sa} = \Delta t_{sum} - T_M \ln \frac{e_k - (h_2 + K_M)i_{s-1}}{r_{s-1} - K_M i_{s-1}}$$

wherein $h_2$ is the value of the switch-off threshold of the hysteresis of the modulator, and $i_{s-1}$ is the preceding switch state.

4. Method according to claim 1, characterised in that to simulate a pseudo rate modulator the switch-on moments $t_{se}$ within the respective time interval $\Delta t_k$ are calculated in accordance with the following formula:

$$t_{se} = \Delta t_{sum} + T_M \left(\frac{r_{s-1}}{e_k - h_1 \text{sign}(e_k)} - 1\right)$$

5. Method according to claim 1 or 4, characterised in that in order to simulate a pseudo rate modulator the switch-off moments $t_{sa}$ within the respective time interval $\Delta t_k$ are calculated in accordance with the following formula:

$$t_{sa} = \Delta t_{sum} + T_M \left(\frac{r_{s-1} - K_M i_{s-1}}{e_k - (h_2 + K_M)i_{s-1}} - 1\right)$$

6. Method according to one of the preceding claims, characterised in that the calculation of the sequence of switch-on and switch-off moments $t_{se}$ and $t_{sa}$ for each individual time interval $\Delta t_k$ is interrupted when the sum $\Delta t_{sum}$ of all

the switch-on and switch-off intervals $\Delta t_{se}$, $\Delta t_{sa}$ accumulating hitherto within the time interval $\Delta t_k$ between the switch-on and switch-off moments and vice versa exceeds the length of the time interval.

7. Method according to claim 6, characterised in that a return signal $r_s$ associated with the, final moment of a time interval $\Delta t_k$ ending in the switched-off state ($i_s = 0$) is calculated in accordance with one of the following formulae:

$$r_s = r_{s-1} \exp\left(- \frac{\Delta t_k - \Delta t_{sum}}{T_M}\right)$$

or

$$r_s = \frac{r_{s-1}\, T_M}{T_M + \Delta t_k - \Delta t_{sum}}$$

8. Method according to claim 6, characterised in that a return signal $r_s$ associated with the final moment of a time interval $\Delta t_k$ ending in the switched-on state ($i_s = \pm 1$) is calculated in accordance with the following formulae:

$$r_s = (r_{s-1} - K_M i_{s-1}) \exp\left(- \frac{\Delta t_k - \Delta t_{sum}}{T_M}\right) + K_M i_{s-1}$$

or

$$r_s = \frac{T_M(r_{s-1} - K_M i_{s-1})}{T_M + \Delta t_k - \Delta t_{sum}} + K_M i_{s-1}$$

## Revendications

1. Procédé de modulation numérique pour la transformation d'un signal d'entrée respectivement constant pendant la durée de chaque intervalle temporel individuel d'une série d'intervalles temporels successifs, en signaux de sortie qui représentent une suite d'impulsions positives et/ou négatives d'amplitude constante et de largeur d'impulsion et de fréquence d'impulsion variable, dans lequel le signal d'entrée et les paramètres de modulation sont amenés à un appareil de calcul,
caractérisé en ce que l'on calcule directement au moyen de l'appareil de calcul au début de chaque intervalle temporel $\Delta t_k$ simplement les points d'enclenchement et de déclenchement $t_{se}$, $t_{sa}$ des impulsions ainsi que leurs signes pour l'intervalle temporel respectivement en cours $Dt_k$, et qu'on les prépare à titre de signaux de sortie.

2. Procédé selon la revendication 1, caractérisé en ce que pour imiter un modulateur pseudo-proportionnel, on calcule les points d'enclenchement $t_{se}$ à l'intérieur de l'intervalle temporel respectif $\Delta t_k$ selon l'équation suivante :

$$t_{se} = \Delta t_{sum} - T_M I_n\, [e_k - h_1 \operatorname{sign}(e_K)]/[r_{s-1}]$$

dans laquelle $e_k$ signifie le signal d'entrée pendant le k-ième intervalle temporel, $h_1$ signifie la valeur du seuil d'enclenchement de l'hystérésis du modulateur, $T_M$ représente la constante temporelle dans la ligne de retour du modulateur, $r_{s-1}$ représente le signal de retour du modulateur vers l'instant de déclenchement précédent respectif $t_{sa}$, et $\Delta t_{sum}$ représente la somme des intervalles entre enclenchement et déclenchement situés respectivement entre les points d'enclenchement et de déclenchement ou inversement, calculés auparavant pour l'intervalle temporel en cours $\Delta t_k$.

3. Procédé selon l'une ou l'autre des revendications 1 et 2, caractérisé en ce que, pour imiter un modulateur pseudo proportionnel, on calcule les instants de déclenchement $t_{sa}$ à l'intérieur de l'intervalle temporel respectif $\Delta t_k$ selon l'équation suivante :

$$t_{sa} = \Delta t_{sum} - T_M\, I_n\, [e_k - (h_2 + K_M) i_{s-1}]/[r_{s-1} - K_M\, i_{s-1}]$$

dans laquelle $h_2$ signifie la valeur du seuil de déclenchement de l'hystérésis du modulateur, et $i_{s-1}$ signifie l'état de commutation précédent.

4. Procédé selon la revendication 1, caractérisé en ce que, pour imiter un modulateur pseudo proportionnel, on calcule les instants d'enclenchement $t_{se}$ à l'intérieur de l'intervalle temporel respectif $\Delta t_k$ selon l'équation suivante :

$$t_{se} = \Delta t_{sum} - T_M \{[r_{s-1}]/[ek - h_1 \; sign(e_k)] - 1\}.$$

5. Procédé selon l'une ou l'autre des revendications 1 et 4, caractérisé en ce que, pour imiter un modulateur pseudo proportionnel, on calcule les instants de déclenchement $t_{sa}$ à l'intérieur de l'intervalle temporel respectif $\Delta t_k$ selon l'équation suivante :

$$t_{se} = \Delta t_{sum} - T_M \{[r_{s-1} - K_M \; i_{s-1}]/[e_k - (h_2 + K_M) \; i_{s-1}] - 1\}.$$

6. Procédé selon l'une des revendications précédentes, caractérisé en ce que le calcul de la succession des instants d'enclenchement et de déclenchement $t_{se}$ et $t_{sa}$ pour chaque intervalle de temps individuel $\Delta t_k$ est interrompu lorsque la somme $Dt_{sum}$ de tous les intervalles entre enclenchement et déclenchement $\Delta t_{se}$, respectivement $\Delta t_{sa}$, écoulés à l'intérieur de l'intervalle temporel $\Delta t_k$ et situés entre les instants d'enclenchement et de déclenchement et inversement, dépasse la longueur de l'intervalle temporel.

7. Procédé selon la revendication 6, caractérisé en ce que l'on calcule un signal de retour $r_s$ associé à l'instant final d'un intervalle temporel $\Delta t_k$ qui se termine à l'état déclenché ($i_s = 0$) selon l'une des équations suivantes :

$$r_s = r_{s-1} \; exp \; [- (\Delta t_k - \Delta t_{sum})/T_M]$$

ou bien

$$r_s = [(r_{s-1} \; T_M)/(T_M + \Delta t_k - \Delta t_{sum})].$$

8. Procédé selon la revendication 6, caractérisé en ce que l'on calcule un signal de retour $r_s$ associé à l'instant final d'un intervalle temporel $\Delta t_k$ qui se termine à l'état enclenché ($i_s = \pm 1$) selon l'une des équations suivantes :

$$r_s = (r_{s-1} - K_M \; i_{s-1}) \; exp \; [- (\Delta t_k - \Delta t_{sum})/T_M] + K_M \; i_{s-1}$$

ou bien

$$r_s = [T_M \; (r_{s-1} - K_M \; i_{s-1})/(T_M + \Delta t_k - \Delta t_{sum})] + K_M \; i_{s-1}.$$

FIG. 1

FIG. 2

# FIG. 3

$(e_k)$

$h_1, h_2$
$K_M, T_M$

$(\Delta t_k)$

4

**21**
$$r_{s-1} = r_k$$
$$i_{s-1} = i_k$$
$$\Delta t_{sum} = 0$$

**23**
$$r_{s-1} = r_s$$
$$i_{s-1} = i_s$$
$$\Delta t_{sum} = t_{se}, t_{sa}$$

**25** JA $\quad i_{s-1} = 0 \ ?$ NEIN

**28**
$$h_{s1} := h_1 \cdot \text{sign}(e_k)$$
$$a_{s1} := \frac{e_k - h_{s1}}{r_{s-1}}$$
$$\Delta t_{s1} = -T_M \ln a_{s1}$$
$$t_{se} = \Delta t_{sum} + \Delta t_{s1}$$

**29**
$$h_{s2} := h_2 \cdot i_{s-1}$$
$$a_{s2} := \frac{e_k - h_{s2} - K_M i_{s-1}}{r_{s-1} - K_M i_{s-1}}$$
$$\Delta t_{s2} = -T_M \ln a_{s2}$$
$$t_{sa} = \Delta t_{sum} + \Delta t_{s2}$$

NEIN $\quad t_{se} \le \Delta t_k \ ? \quad$ JA **26**

JA $\quad t_{sa} \le \Delta t_k \ ? \quad$ NEIN **27**

**32**
$$i_s = \text{sign}(e_k)$$
$$r_s = e_k - h_{s1}$$

**33**
$$i_s = 0$$
$$r_s = e_k - h_{s2}$$

**30**
$$i_s = i_{s-1}$$
$$\phi = e^{-(\Delta t_k - \Delta t_{sum})/T_M}$$
$$r_s = \phi \, r_{s-1}$$

**31**
$$i_s = i_{s-1}$$
$$\phi = e^{-(\Delta t_k - \Delta t_{sum})/T_M}$$
$$r_s = \phi \, r_{s-1} + K_M i_{s-1}(1-\phi)$$

**22**
$$i_s, r_s$$
$$i_s(i_k, i_{s-1}, i_s, i_{s+1}, \ldots)$$
$$t_s(t_{se1}, t_{sa1}, t_{se2}, \ldots)$$
$$i_s, r_s$$

$t_s$

$r_s \to r_k \quad i_s \to i_k$

$i_s(t_s)$